# EUROPÄISCHE PATENTSCHRIFT

(11) **EP 3 611 497 B1**
(45) Veröffentlichungstag und Bekanntmachung des Hinweises auf die Patenterteilung: **23.07.2025**
(21) Anmeldenummer: 18188622.7
(22) Anmeldetag: 13.08.2018
(51) Int. Cl.: G01N 21/952, H01R 43/28, G02B 7/182, G02B 13/06, G02B 27/14, H01R 43/05, G01R 31/69

(54) **ÜBERPRÜFUNGSVORRICHTUNG ZUM ÜBERPRÜFEN EINER KABELSPITZE EINES KABELS UND VERFAHREN ZUM REINIGEN DER SPIEGEL EINER ÜBERPRÜFUNGSVORRICHTUNG**
INSPECTION APPARATUS FOR INSPECTING A CABLE TIP OF A CABLE AND METHOD FOR CLEANING THE MIRROR OF AN INSPECTION APPARATUS
DISPOSITIF DE VÉRIFICATION DESTINÉ À VÉRIFIER UNE POINTE DE CÂBLE D'UN CÂBLE ET PROCÉDÉ DE NETTOYAGE DU MIROIR D'UN DISPOSITIF DE VÉRIFICATION

(43) Veröffentlichungstag der Anmeldung: 19.02.2020
(73) Patentinhaber: KOMAX HOLDING AG, 6036 Dierikon (CH)
(72) Erfinder: GISLER, Adrian, 6274 Eschenbach (CH); KISER, Markus, 6382 Büren (CH); STOCKER, Martin, 6403 Küssnacht (CH)
(74) Vertreter: Inventio AG

(56) Entgegenhaltungen:
- EP-A1- 1 296 162
- EP-A1- 3 109 624

## Beschreibung

Die vorliegende Erfindung betrifft eine Überprüfungsvorrichtung zum Überprüfen einer Kabelspitze eines Kabels und ein Verfahren zum Reinigen der Spiegel einer Überprüfungsvorrichtung.

Die EP 3 109 624 A1 beschreibt eine Überprüfungsvorrichtung zum Überprüfen einer Kabelspitze eines Kabels gemäß des Stands der Technik. Die Überprüfungsvorrichtung in der EP 3 109 624 A1 umfasst eine Kamera, eine Beleuchtungseinrichtung und einen konischen Spiegelkragen (d.h. eine konische Anordnung von Einzelspiegeln um eine Zentralachse). Zur Überprüfung der Kabelspitze bzw. Qualitätsprüfung wird eine Kabelspitze in den konischen Spiegelkragen eingeführt, wo eine Kamera die Spiegelbilder der Kabelspitze aufnimmt. Diese Aufnahme wird mit einer Software beurteilt, d.h. die Kabelspitze wird auf ihre Qualität hin geprüft. Die Prüfung findet vor und nach dem Crimpen statt, um die Qualität der Abisolierung und der Verbindung des Crimpkontakts mit dem Kabel (d.h. die Crimpverbindung) zu überprüfen bzw. sicherzustellen. Dies kann durch zweimaliges Einbringen der Kabelspitze in eine einzelne Überprüfungsvorrichtung geschehen oder mittels zweier separater Überprüfungsvorrichtungen durchgeführt werden.

Ein zu beachtender Aspekt von Überprüfungsvorrichtungen ist die Verunreinigung von Teilen der Überprüfungsvorrichtung, insbesondere der Kamera und/oder der Spiegel, mit Schmutz und/oder Staub, insbesondere von dem zu überprüfenden Kabel, was zu Fehlern in der Qualitätsprüfung mittels der Kamera führen kann. Ohne die Reinigung der Spiegel ist die Überprüfung der Kabelspitze mittels der Überprüfungsvorrichtung unter ungünstigen Umständen schon nach einem Tag nicht mehr zuverlässig möglich.

Die EP 3 109 624 A1 schlägt vor, die Verschmutzung zu reduzieren, indem die Elemente der Überprüfungsvorrichtung (d.h. Kamera, Beleuchtungseinrichtung und konischer Spiegelkragen) in ein Gehäuse platziert werden, in welchem ein Überdruck erzeugt wird. Dadurch soll ein Eindringen von Schmutzteilchen in das Gehäuse verhindert werden.

Nachteilig an bisher bekannten Überprüfungsvorrichtungen ist, dass die Spiegel geklemmt und/oder aufwändig auf einen Spiegelträger geklebt sind, wobei die Ausrichtung der Spiegel beachtet bzw. eingestellt werden muss. Dabei ist die Zwischenschicht aus Klebstoff zwischen Spiegel und Spiegelträger bzw. Spiegelvorrichtung besonders problematisch. Da meist die gesamte Kontaktfläche zwischen Spiegelvorrichtung bzw. Spiegelträger und Spiegel zum Verkleben verwendet wird, können mechanische Spannungen im Spiegel durch die unterschiedlichen Wärmeausdehnungen der verschiedenen Materialien (Klebstoff, Spiegel, Spiegelträger bzw. Spiegelvorrichtung) entstehen. Dies kann zu optischen Beeinträchtigungen beim Betrachten der Reflexionen der Spiegel und/oder zu Beschädigungen der Spiegel führen. Zudem sind die Spiegelträger bisher mit der Spiegelvorrichtung verschraubt. Beim Reinigen der Spiegel außerhalb der Überprüfungsvorrichtung, was von Zeit zu Zeit notwendig ist, wird der Spiegelkragen bzw. die Spiegelvorrichtung insgesamt gehandhabt bzw. gehalten, da die Spiegelträger an der Spiegelvorrichtung mittels Schrauben befestigt sind. Auch das erneute Befestigen bzw. Ausrichten der Spiegel in der Spiegelvorrichtung nach dem Lösen bzw. Entfernen eines einzelnen Spiegelträgers ist technisch aufwändig. Zudem sind die Spiegelträger, mittels denen die Spiegel in der Spiegelvorrichtung befestigt und ausgerichtet sind, oftmals sehr schwer, so dass die Handhabung der Spiegel (mit dem Spiegelträger) beim Reinigen der Spiegel schwierig bzw. aufwändig ist. Es kann unter anderem ein Bedarf an einer Überprüfungsvorrichtung zum Überprüfen einer Kabelspitze eines Kabels bestehen, bei der das Einsetzen und/oder Entfernen von Spiegeln der Überprüfungsvorrichtung technisch einfach durchführbar ist. Zudem kann unter anderem ein Bedarf an einem Verfahren zum Reinigen der Spiegel einer Überprüfungsvorrichtung bestehen, mittels dem die Spiegel technisch einfach gereinigt werden und die Spiegel nach dem Reinigen technisch einfach in die Überprüfungsvorrichtung eingesetzt werden.

EP1296162A1betrifft einen Polygonreflektor und dessen Verwendung in einem optischen Belichtungssystem einer Photolithographieanlage.

Einem solchen Bedarf kann durch eine Überprüfungsvorrichtung zum Überprüfen einer Kabelspitze eines Kabels gemäß dem unabhängigen Anspruch 1 bzw. einem Verfahren zum Reinigen der Spiegel einer Überprüfungsvorrichtung gemäß dem Anspruch 13 entsprochen werden. Vorteilhafte Ausführungsformen sind in den abhängigen Ansprüchen definiert.

Gemäß einem ersten Aspekt der Erfindung wird eine Überprüfungsvorrichtung zum Überprüfen einer Kabelspitze eines Kabels, insbesondere eines verarbeiteten Kabels, vorzugsweise eines mit einem Crimpkontakt über eine Crimpverbindung verbundenen Kabels, vorgeschlagen, wobei die Überprüfungsvorrichtung eine Spiegelvorrichtung mit einer Zentralachse aufweist, wobei die Kabelspitze zum Überprüfen der Kabelspitze entlang der Zentralachse in der Spiegelvorrichtung anordenbar ist, wobei die Spiegelvorrichtung mehrere in einem vorgegebenen Winkel zueinander und in einem vorgegebenen Winkel zu der Zentralachse angeordnete Spiegelelemente jeweils umfassend einen Spiegel zum Betrachten der entlang der Zentralachse der Spiegelvorrichtung angeordneten Kabelspitze aus unterschiedlichen Blickwinkeln umfasst, wobei die Überprüfungsvorrichtung ferner eine Kamera zum Erzeugen von Bildern der Kabelspitze aus unterschiedlichen Blickwinkeln mittels der Spiegel umfasst, dadurch gekennzeichnet, dass zumindest ein Teil der Spiegelelemente, insbesondere alle Spiegelelemente, in der Spiegelvorrichtung von Magneten an ihrer jeweiligen Position gehalten werden.

Vorteilhaft hieran ist, dass die Spiegelelemente bzw. die Spiegel typischerweise technisch einfach jeweils an ihrer Position gehalten werden. Zudem kann die Verbindung zwischen der Spiegelvorrichtung und den Spiegelelementen bzw. Spiegeln im Allgemeinen zerstörungsfrei bzw. reversibel technisch einfach gelöst und einfach wieder hergestellt werden. Insbesondere können die Spiegelelemente üblicherweise technisch einfach der Spiegelvorrichtung z.B. für eine Reinigung entnommen und wieder in die Spiegelvorrichtung eingesetzt werden. Darüber hinaus wird das Auftreten von mechanischen Spannungen in den Spiegeln typischerweise technisch einfach verhindert. Zudem können die Spiegelelemente typischerweise technisch einfach in Bezug auf die Spiegelvorrichtung ausgerichtet werden. Auch können die Spiegelelemente in der Regel ein geringes Gewicht aufweisen, wodurch die Handhabung der Spiegelelemente besonders einfach ist. Die Spiegelelemente können der Spiegelvorrichtung üblicherweise technisch einfach einzeln entnommen werden, wodurch der Reinigungsvorgang im Allgemeinen technisch noch einfacher ist.

Gemäß einem zweiten Aspekt der Erfindung wird ein Verfahren zum Reinigen der Spiegel einer Überprüfungsvorrichtung zum Überprüfen einer Kabelspitze eines Kabels wie vorstehend beschrieben vorgeschlagen,
wobei die Überprüfungsvorrichtung eine Spiegelvorrichtung mit einer Zentralachse aufweist, wobei die Kabelspitze zum Überprüfen der Kabelspitze entlang der Zentralachse in der Spiegelvorrichtung anordenbar ist, wobei die Spiegelvorrichtung mehrere in einem vorgegebenen Winkel zueinander und in einem vorgegebenen Winkel zu der Zentralachse angeordnete Spiegelelemente jeweils umfassend einen Spiegel zum Betrachten der entlang der Zentralachse der Spiegelvorrichtung angeordneten Kabelspitze aus unterschiedlichen Blickwinkeln umfasst, wobei die Überprüfungsvorrichtung ferner eine Kamera zum Erzeugen von Bildern der Kabelspitze aus unterschiedlichen Blickwinkeln mittels der Spiegel umfasst, wobei das Verfahren folgende Schritte umfasst: Herausnehmen der Spiegelvorrichtung aus der Überprüfungsvorrichtung; Lösen einer magnetischen Verbindung zwischen mindestens einem der Spiegelelemente und der Spiegelvorrichtung und Entnehmen des mindestens einen Spiegelelements aus der Spiegelvorrichtung; Reinigen des Spiegels des mindestens einen Spiegelelements; Einsetzen des gereinigten mindestens einen Spiegelelements in die Spiegelvorrichtung in einer vorgegebenen Position und Befestigen des Spiegelelements mittels eines Magneten an der Spiegelvorrichtung; und Einsetzen der Spiegelvorrichtung in die Überprüfungsvorrichtung.

Hierdurch werden die Spiegelelemente typischerweise technisch einfach gereinigt. Insbesondere muss üblicherweise keine Verbindung technisch aufwendig (z.B. eine Schraubverbindung) gelöst werden, um die Spiegelelemente der Spiegelvorrichtung zu entnehmen. Zudem werden die Spiegelelemente typischerweise technisch einfach wieder in die Spiegelvorrichtung eingesetzt. Darüber hinaus wird im Allgemeinen das Auftreten von mechanischen Spannungen in den Spiegeln technisch einfach verhindert. Somit ist der Reinigungsvorgang technisch besonders einfach durchführbar. Auch können die Spiegelelemente in der Regel ein geringes Gewicht aufweisen, wodurch die Handhabung der Spiegelelemente besonders einfach ist. Die Spiegelelemente können der Spiegelvorrichtung üblicherweise technisch einfach einzeln entnommen werden, wodurch der Reinigungsvorgang im Allgemeinen technisch noch einfacher ist. Zudem können die Spiegelelemente im Allgemeinen unempfindlich in Bezug auf Stöße oder ähnliches ausgebildet sein. Insbesondere kann sich die Person, die die Reinigung vornimmt, typischerweise darauf konzentrieren, die Spiegel bzw. Spiegelelemente der Spiegelvorrichtung zu entnehmen, da die Spiegelelemente über die Magnete gehalten werden (und somit das Lösen der Spiegelelemente aus der Spiegelvorrichtung technisch einfach ist) und die Spiegelelemente ein geringes Gewicht aufweisen können (und somit die Handhabung der Spiegelelemente besonders einfach ist).

Mögliche Merkmale und Vorteile von Ausführungsformen der Erfindung können unter anderem und ohne die Erfindung einzuschränken als auf nachfolgend beschriebenen Ideen und Erkenntnissen beruhend angesehen werden.

Gemäß einer Ausführungsform der Überprüfungsvorrichtung weisen die Spiegelelemente ferner jeweils eine Platte, insbesondere eine Metallplatte, auf, wobei die Spiegel jeweils mit der Platte, insbesondere mittels einer Klebeverbindung, fest verbunden sind, wobei die Platten jeweils ein derartiges Material umfassen, dass die Platten von Magneten angezogen werden können. Vorteilhaft hieran ist, dass die Spiegel technisch einfach und in einer vorgegebenen Position mit der Spiegelvorrichtung verbunden werden können.

Gemäß einer Ausführungsform der Überprüfungsvorrichtung umfassen die Platten jeweils eine Klebeaussparung oder mehrere Klebeaussparungen zum Aufnehmen eines Klebstoffs der Klebeverbindung. Ein Vorteil hiervon ist, dass die Spiegel besonders präzise parallel zu der jeweiligen Platte angeordnet werden können.

Gemäß einer Ausführungsform der Überprüfungsvorrichtung weist die jeweilige Platte in der Klebeaussparung an einem dem Spiegel abgewandten Ende eine Fase zum verbesserten Verbinden des Klebstoffs mit der Platte auf. Hierdurch kann die Verbindung zwischen der Platte und dem Klebstoff verbessert werden bzw. noch sicherer hergestellt werden.

Gemäß einer Ausführungsform der Überprüfungsvorrichtung entspricht die jeweilige Größe der Kontaktfläche des Klebstoffs mit dem jeweiligen Spiegel im Wesentlichen einem Durchmesser der jeweiligen Klebeaussparung zum Aufnehmen des Klebstoffs parallel zu der Oberfläche der Platte. Vorteilhaft hieran ist, dass ein etwaiges Ausdehnen und/oder Schrumpfen der Platte und/oder des Spiegels und/oder des Klebstoffs durch Temperaturänderungen die Verbindung zwischen der Platte und dem jeweiligen Spiegel nicht negativ beeinträchtigt. Da die Verbindung zwischen der Platte und dem jeweiligen Spiegel nur über eine Oberfläche vorhanden ist, die dem Durchmesser der Klebeaussparung entspricht, wird ein Entstehen von mechanischen Spannungen oder gar ein Verbiegen des Spiegels und/oder der Platte durch Temperaturänderungen im Wesentlichen verhindert. Somit wird sichergestellt, dass die Oberfläche des jeweiligen Spiegels stets parallel zu der Oberfläche der Platte verläuft.

Gemäß einer Ausführungsform der Überprüfungsvorrichtung umfasst die Spiegelvorrichtung Auflageflächen zum Aufliegen von Spiegelrückflächen der Spiegel der Spiegelelemente, wobei die Auflageflächen jeweils eine Aussparung zum Aufnehmen der jeweiligen Platte aufweisen. Vorteilhaft hieran ist, dass die Spiegel technisch einfach ausgerichtet werden, so dass der jeweilige Spiegel nach dem Einsetzen ohne weitere Maßnahmen relativ zu Zentralachse und den anderen Spiegeln technisch einfach ausgerichtet ist. Somit wird der Spiegel in einer ersten Richtung an einer vorgegebenen Stelle gehalten bzw. positioniert, da sich der jeweilige Spiegel bzw. das jeweilige Spiegelelement in einer Richtung senkrecht zur jeweiligen Auflagefläche im Wesentlichen nicht bewegen kann.

Gemäß einer Ausführungsform der Überprüfungsvorrichtung sind Anschläge an den der Zentralachse der Überprüfungsvorrichtung abgewandten Enden der Platten zum Halten der Spiegelelemente in jeweils einer vorgegebenen Position in der Spiegelvorrichtung angeordnet. Hierdurch wird ein Herunterrutschen bzw. ein Bewegen des jeweiligen Spiegelelements parallel zu einer Auflagefläche des Spiegels, auf dem der Spiegel mit seiner Spiegelrückfläche aufliegt, weg von der Zentralachse technisch einfach verhindert. Somit wird der Spiegel bzw. das Spiegelelement in einer zweiten Richtung an einer vorgegebenen Stelle gehalten bzw. positioniert.

Gemäß einer Ausführungsform der Überprüfungsvorrichtung weist die Spiegelvorrichtung eine Vielzahl von seitlichen Spiegelbegrenzungen auf, wobei die seitlichen Spiegelbegrenzungen an jeweils zwei einander gegenüberliegenden Seiten des jeweiligen Spiegels zum Halten des jeweiligen Spiegels in einer vorgegebenen Position angeordnet sind. Vorteilhaft hieran ist, dass die Spiegel an zwei (weiteren) Seiten in ihrer jeweiligen vorgegebenen Position gehalten werden. Somit wird der Spiegel in einer dritten Richtung an einer vorgegebenen Stelle gehalten bzw. positioniert. Zusammen mit dem Anschlag und der Auflagefläche ist somit das jeweilige Spiegelelement und folglich der jeweilige Spiegel in alle drei Raumdimensionen an der vorgegebenen Position relativ zu der Zentralachse gehalten bzw. relativ zu der Zentralachse ausgerichtet.

Gemäß einer Ausführungsform der Überprüfungsvorrichtung ist die Überprüfungsvorrichtung derart ausgebildet, dass die Spiegelvorrichtung aus der Überprüfungsvorrichtung entnehmbar und in die Überprüfungsvorrichtung einsetzbar ist. Vorteilhaft hieran ist, dass man die Spiegelelemente bzw. Spiegel technisch besonders einfach der Spiegelvorrichtung entnehmen kann. Zudem können die Spiegelelemente bzw. Spiegel technisch einfach wieder in die Spiegelvorrichtung eingesetzt werden. Darüber hinaus kann die Spiegelvorrichtung technisch einfach gegen eine andere Spiegelvorrichtung ausgetauscht bzw. ausgewechselt werden.

Gemäß einer Ausführungsform der Überprüfungsvorrichtung sind die Platten der Spiegelelemente jeweils beabstandet zu den Magneten angeordnet. Hierdurch sind die Spiegel noch präziser relativ zu der Zentralachse ausgerichtet. Zudem entstehen durch Ausdehnungen und/oder Schrumpfungen aufgrund von Temperaturveränderungen keine mechanischen Spannungen in dem Spiegelelement bzw. in der Platte. Dies führt zu einer besonders zuverlässigen Ausrichtung der Spiegelelemente bzw. der Spiegel relativ zu der Zentralachse.

Gemäß einer Ausführungsform der Überprüfungsvorrichtung weist jeder der Spiegel in einer Aufsicht eine trapezförmige Form auf, und ein Ende der Platte schließt plan mit der kürzeren der beiden parallel zueinander verlaufenden Seiten des Spiegels ab. Hierdurch können die Spiegel besonders präzise ausgerichtet werden. Zudem kann die Platte besonders präzise relativ zu dem Spiegel ausgerichtet werden.

Gemäß einer Ausführungsform der Überprüfungsvorrichtung ist die Spiegelvorrichtung bezüglich der Zentralachse spiegelsymmetrisch ausgebildet. Vorteilhaft hieran ist, dass die Orientierung der Spiegelvorrichtung beim Einsetzen in die Überprüfungsvorrichtung typischerweise unbeachtlich ist. Somit kann im Allgemeinen die Spiegelvorrichtung ohne Überprüfung einer bestimmten Orientierung der Spiegelvorrichtung bezüglich der Zentralachse in die Überprüfungsvorrichtung eingesetzt werden. Dies erleichtert üblicherweise das Einsetzen der Spiegelvorrichtung.

Gemäß einer Ausführungsform der Überprüfungsvorrichtung ist jedes Spiegelelement mittels zwei Magneten an der Spiegelvorrichtung befestigt ist, wobei die Magnete in Vertiefungen der Aussparung angeordnet sind. Vorteilhaft hieran ist, dass die Spiegelvorrichtung typischerweise sehr kompakt ausgebildet sein kann. Zudem sind die Spiegelelemente im Allgemeinen besonders zuverlässig an der Spiegelvorrichtung befestigt.

Gemäß einer Ausführungsform des Verfahren umfasst das Verfahren ferner folgenden Schritt: Befestigen des mindestens einen Spiegelelements an einer Spiegelhaltevorrichtung mittels Magneten zum Halten des Spiegelelements während des Reinigens des Spiegels. Vorteilhaft hieran ist, dass die Spiegelelemente typischerweise technisch einfach gehalten werden während des Reinigungsvorgangs.

Es wird darauf hingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine perspektivische Teilschnittansicht einer Ausführungsform der erfindungsgemäßen Überprüfungsvorrichtung;
- Fig. 2 zeigt: eine seitliche Schnittansicht der Überprüfungsvorrichtung aus Fig. 1;
- Fig. 3 zeigt: eine perspektivische Ansicht der Spiegelvorrichtung der Überprüfungsvorrichtung aus Fig. 1 bzw. Fig. 2;
- Fig. 4 zeigt: eine Schnittansicht der Spiegelvorrichtung aus Fig. 3;
- Fig. 5 zeigt: eine perspektivische Ansicht der Spiegelvorrichtung aus Fig. 3, ohne einige Spiegel;
- Fig. 6 zeigt: eine perspektivische Ansicht eines Spiegelelements der Überprüfungsvorrichtung aus Fig. 1 bzw. Fig. 2; und
- Fig. 7 zeigt: ein mit der Überprüfungsvorrichtung aus Fig. 1 aufgenommenes Bild der Kabelspitze.

Die Figuren sind lediglich schematisch und nicht maßstabsgetreu. Gleiche Bezugszeichen bezeichnen in den verschiedenen Figuren gleiche oder gleichwirkende Merkmale

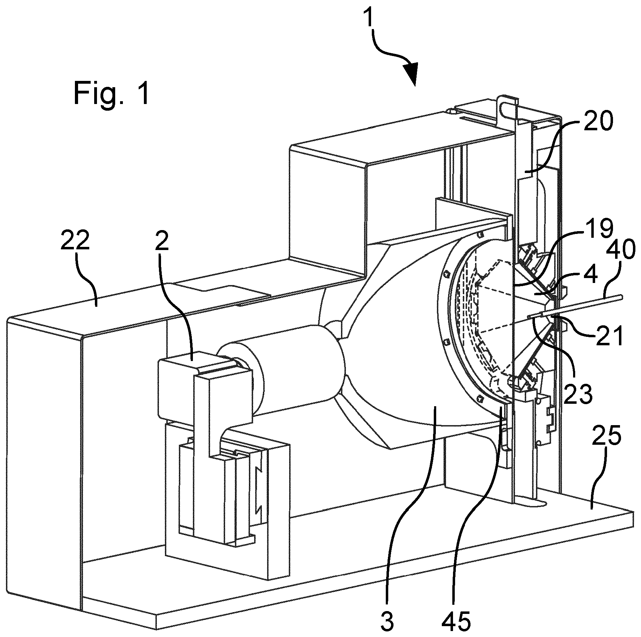

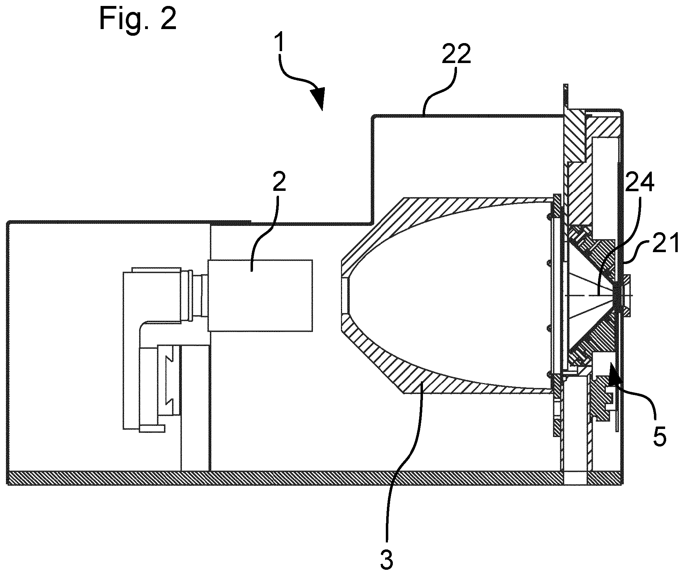

Fig. 1 zeigt eine perspektivische Teilschnittansicht einer Ausführungsform der erfindungsgemäßen Überprüfungsvorrichtung. Fig. 2 zeigt eine seitliche Schnittansicht der Überprüfungsvorrichtung aus Fig. 1.

Die Überprüfungsvorrichtung 1 ist zum Überprüfen bzw. Inspizieren einer Kabelspitze 23 bzw. eines Kabelendes eines Kabels 40 ausgebildet. Hierzu weist die Überprüfungsvorrichtung 1 eine Spiegelvorrichtung 5, eine Beleuchtungseinrichtung 3 und eine Kamera 2 auf.

Das Kabel 40 bzw. die Kabelspitze 23 wird in die Spiegelvorrichtung 5 entlang einer Zentralachse 24 der Spiegelvorrichtung 5, wobei die Zentralachse 24 horizontal verläuft, durch eine Kabelaufnahmeöffnung 30 eingeführt. Das Kabel 40 wird mittels einer Kabelzentrierung 21 in dieser Position gehalten. Die Zentralachse 24 verläuft mittig durch die Kabelaufnahmeöffnung 30 der Spiegelvorrichtung 5.

Die Kabelzentrierung 21 weist einen ersten vertikal beweglichen Parallelgreifer, der zwei Klemmplatten aufeinander zu bewegen kann, und einen zweiten horizontal beweglichen Parallelgreifer, der ebenfalls zwei Klemmplatten aufeinander zu bewegen kann, auf. Durch die vier Klemmplatten wird das Kabel 40 gehalten und gleichzeitig zentriert, so dass das Kabel 40 bzw. die Kabelspitze 23 in der Spiegelvorrichtung 5 entlang der Zentralachse 24 verläuft.

Die Spiegelvorrichtung 5 umfasst eine Vielzahl von Spiegeln 60-67 in Form eines Spiegelkragens 4 um die Zentralachse 24 bzw. die Kabelspitze 23.

Die Spiegel 60-67 der Spiegelvorrichtung 5 sind jeweils in einem gleichen Winkel zueinander angeordnet und umgeben die Zentralachse 24 vollständig. Beispielsweise kann die Spiegelvorrichtung 5 acht Spiegel 60-67 umfassen, so dass jeder Spiegel 60-67 jeweils in einem Winkel von 360°/8 = 45° zu dem unmittelbar benachbarten Spiegel 60-67 ausgerichtet ist. Es ist auch denkbar, dass die Spiegelvorrichtung 5 nur fünf oder sechs Spiegel 60-67 umfasst, die die Kabelspitze 23 vollständig umgeben.

Zudem sind die Spiegel 60-67 derart angeordnet, dass sie konisch auf die Kabelaufnahmeöffnung 30 zulaufen, d.h. der Abstand der Spiegel 60-67 zu der Zentralachse 24 wird kleiner je mehr man sich auf die Kabelaufnahmeöffnung 30 zubewegt.

Die Spiegel 60-67 weisen jeweils einen Winkel von ca. 45° zu der Zentralachse 24 auf. Die Spiegel 60-67 sind jeweils in Aufsicht trapezförmig ausgebildet. Die Dicke des Spiegels 60-67, die in Richtung der Aufsicht verläuft, ist gering im Vergleich zu den Ausdehnungen des Trapezes des Spiegels 60-67.

Ein oder mehrere Spiegel 60-67 können jeweils Distanzmarkierungen aufweisen, um als Bezug für Messoperationen bei der Auswertung der von der Kamera 2 aufgenommenen Bilder zu dienen.

Eine durchsichtige Scheibe 19 trennt die Kamera 2 und die Beleuchtungseinrichtung 3 auf einer ersten Seite der Scheibe 19 von der Spiegelvorrichtung 5 auf einer zweiten Seite der Scheibe 19. Die Scheibe 19 verläuft vertikal.

Die Spiegelvorrichtung 5, die Scheibe 19 und die Kabelzentrierung 21, die die Kabelaufnahmeöffnung 30 fast vollständig verschließt, begrenzen gemeinsam das Innere bzw. den Innenraum der Spiegelvorrichtung 5.

Die Beleuchtungseinrichtung 3 umfasst einen Reflektor in Form eines Rotationsparaboloids auf, der eine Sichtöffnung für die Kamera 2 aufweist. In Fig. 2 befindet sich die Sichtöffnung auf der linken Seite, d.h. der der Spiegelvorrichtung 5 abgewandten Seite des Reflektors bzw. der Beleuchtungseinrichtung 3.

Die Beleuchtungseinrichtung 3 umfasst zudem eine Ringleuchte 45. Die Ringleuchte 45 ist am inneren Rand des Reflektors an dem der Spiegelvorrichtung 5 zugewandten Ende (in Fig. 2 das rechte Ende) des Reflektors angeordnet. Die Beleuchtungseinrichtung 3 bzw. die Ringleuchte 45 ist kreisscheibenförmig ausgebildet und weist eine Vielzahl von Leuchtmitteln, z.B. LEDs, auf, die über den Umfang der Beleuchtungseinrichtung 3 gleichmäßig verteilt angeordnet sind. Die Leuchtmittel sind derart angeordnet, dass sie parallel zu der Zentralachse 24 weg von der Spiegelvorrichtung 5 ihre Hauptabstrahlrichtung ab. Hierdurch gelangt das abgestrahlte Licht auf den Reflektor und anschließend zu der Kabelspitze 23, die somit von vielen Seiten beleuchtet bzw. ausgeleuchtet wird.

Der Reflektor bzw. die innere Oberfläche des Reflektors kann aus einem weißen Kunststoff (z.B. Polytetrafluorethylen (PTFE) oder Polyoxymethylen (POM)) und/oder eine weiße Oberfläche bzw. Farbschicht aufweisen. Die innere Oberfläche, die zum Reflektieren des Lichts von den Leuchtmitteln ausgebildet ist, ist rau ausgeführt, um eine gute Streuung des Lichts zu erreichen. Die Leuchtmittel strahlen alle in Richtung des Reflektors.

Die Blickrichtung der Kamera 2 verläuft entlang der Zentralachse 24. Die Kamera 2 nimmt über Reflexionen der Spiegel 60-67, die um die Kabelspitze 23 herum angeordnet sind, Bilder bzw. Aufnahmen der Kabelspitze 23 aus unterschiedlichen Blickwinkeln auf. Die Anzahl der Blickwinkel hängt von der Anzahl der Spiegel 60-67 ab. Es ist auch möglich, dass die Kamera 2 nur ein Bild aufnimmt, das in mehrere Bilder, nämlich ein Bild pro Spiegel 60-67, aufgeteilt wird bzw. ist. Möglich ist auch, dass für jeden Spiegel 60-67 ein separates Bild von der Kamera 2 oder mehreren Kameras aufgenommen wird.

Die Kamera 2 ist mit einem Auswertungssystem (nicht gezeigt) verbunden. Das Auswertungssystem umfasst z.B. einen Computer mit Auswertungssoftware, wobei die Auswertungssoftware die Bilder der Kabelspitze 23 aus den unterschiedlichen Blickwinkeln analysiert. Die Auswertungssoftware kann eine Bilderkennungsoftware umfassen oder sein. Die Auswertungssoftware kann z.B. Ungleichmäßigkeiten und/oder Asymmetrien und/oder sonstige Fehler, wie z.B. herausgezogene und/oder abgespreizte Litzen des Kabels 40 bzw. der Kabelspitze 23, erkennen. Wenn ein oder mehrere Fehler und/oder Qualitätsmängel von der Auswertungssoftware erkannt wurden, kann eine entsprechende Fehlermeldung erzeugt werden. Auf die Fehlermeldung hin kann z.B. das Kabel 40 als Ausschuss entsorgt werden, die Produktion weiterer Kabel kann vorläufig bis zu einer manuellen Freigabe gestoppt werden oder ähnliches. Auch eine reine Aufzeichnung der festgestellten Variablen kann stattfinden.

Das Kabel 40 kann vor und/oder nach einem Verarbeiten des Kabels 40 mit einer Kabelverarbeitungsmaschine (z.B. einer Crimpmaschine) mittels der Überprüfungsvorrichtung 1 untersucht bzw. überprüft bzw. inspiziert werden, um durchgeführte Veränderungen des Kabels 40 durch die Kabelverarbeitungsmaschine festzustellen.

Die Kamera 2 kann eine digitale Fotokamera oder digitale Videokamera sein.

Zwischen dem Reflektor bzw. der Beleuchtungseinrichtung 3 und der Spiegelvorrichtung 5 ist eine durchsichtige Scheibe 19 angeordnet, die senkrecht zur Zentralachse 24 verläuft. Die Scheibe 19 trennt, insbesondere im Wesentlichen luftdicht, die Spiegelvorrichtung 5 von dem Reflektor bzw. der Beleuchtungseinrichtung 3 und der Kamera 2. Somit kann kein Schmutz und/oder Dreck aus der Spiegelvorrichtung 5 bzw. vom Kabel 40 bzw. der Kabelspitze 23 in den Reflektor und/oder zur Kamera 2 gelangen. Die Spiegelvorrichtung 5 und der Reflektor/die Kamera 2 befinden sich somit auf zwei zueinander gegenüberliegenden Seiten der Scheibe 19.

Ein Gehäuse 22 der Überprüfungsvorrichtung 1 umschließt die Komponenten bzw. Bestandteile der Überprüfungsvorrichtung 1 (d.h. Kamera 2, Reflektor, Scheibe 19 und Spiegelvorrichtung 5), so dass diese vor Staub und/oder Schmutz geschützt sind. Bei geschlossenem Gehäuse 22 verbleibt nur die Kabelaufnahmeöffnung 30, durch die Staub und/oder Schmutz in die Überprüfungsvorrichtung 1 eindringen kann.

Die Überprüfungsvorrichtung 1 umfasst zudem eine Druckluftreinigungsvorrichtung 20. Die Druckluftreinigungsvorrichtung 20 ist zum Reinigen der Scheibe 19 und der Spiegelvorrichtung 5 von Schmutz und/oder Dreck mittels Druckluft ausgebildet

Die Druckluftreinigungsvorrichtung 20 dient zum Reinigen der Scheibe 19 und der Spiegel 60-67 per Druckluft. Wenn die Druckluftreinigungsvorrichtung 20 in die Überprüfungsvorrichtung 1 eingesetzt ist, ist die Druckluftreinigungsvorrichtung 20 bzw. sind die Auslässe der Druckluftreinigungsvorrichtung 20 mit einem stationär angeordneten Druckluftkanal fluidverbunden.

Die Druckluftreinigungsvorrichtung 20 kann der Überprüfungsvorrichtung 1 entnommen und in diese wieder eingesetzt werden. Hierfür weist die Überprüfungsvorrichtung 1 eine Aussparung auf, in die auch ein Kalibrierungselement bzw. eine Graukarte zum Kalibrieren der (Farb-)Kamera 2 eingeführt werden kann.

Die Kamera 2, die Beleuchtungseinrichtung 3, die Scheibe 19 und die Spiegelvorrichtung 5 sind in einer einteiligen oder mehrteiligen Abdeckung 22 angeordnet bzw. eingeschlossen, um das Eindringen von Staub und/oder Schmutz zu verhindern bzw. zumindest zu verringern.

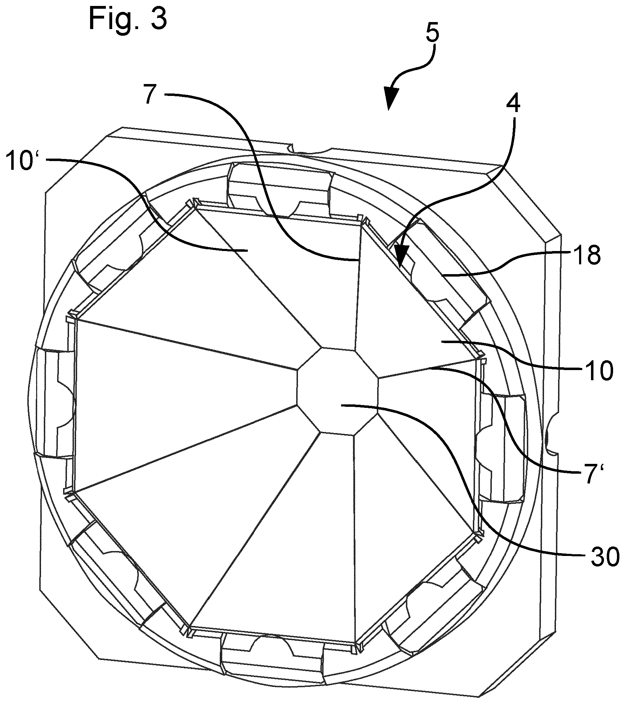

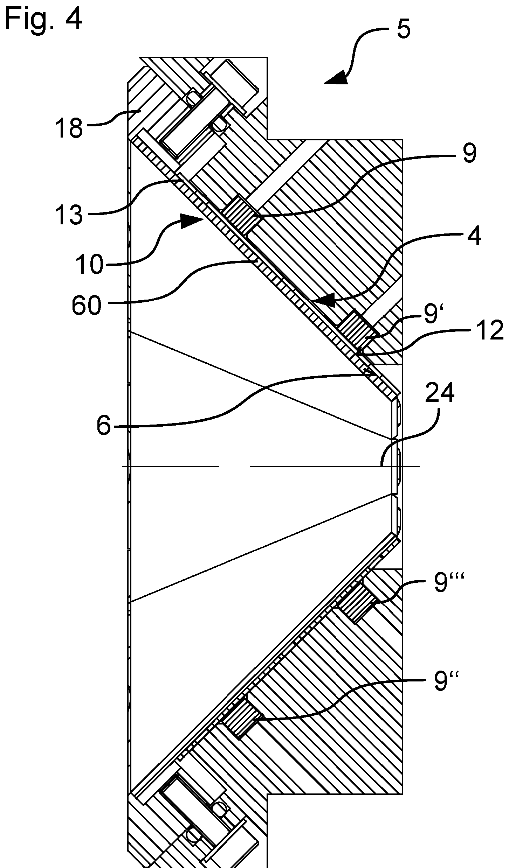

Fig. 3 zeigt eine perspektivische Ansicht der Spiegelvorrichtung der Überprüfungsvorrichtung 1 aus Fig. 1 bzw. Fig. 2. Fig. 4 zeigt eine Schnittansicht der Spiegelvorrichtung 5 aus Fig. 3. Fig. 4 zeigt insbesondere eine Schnittansicht entlang einer Ebene, die die Zentralachse 24 umfasst.

Die Spiegelvorrichtung 5 umfasst eine Vielzahl von Spiegelelementen 10, 10'. Die Spiegelelemente 10, 10' sind in Form eines Spiegelkranzes angeordnet. Jedes Spiegelelement 10, 10' umfasst eine Platte 13 bzw. ein Blech und einen daran befestigten Spiegel 60-67. Der Spiegel 60-67 bzw. die Oberfläche des Spiegels 60-67 ist parallel zu der Oberfläche der Platte 13 bzw. dem Blech angeordnet. Der Spiegel 60-67 ist mit seiner Spiegelrückfläche 12 teilweise mit der Platte 13 bzw. dem Blech verklebt. In Fig. 3 sind die Spiegelrückflächen 12 und somit auch die Platten 13 bzw. Bleche nicht zu sehen.

Das Spiegelelement 10, 10' weist somit keine losen Elemente auf, sondern die Teile des Spiegelelements 10, 10', d.h. Spiegel 60-67 und Blech bzw. Platte 13, sind fest miteinander verklebt.

Die Spiegelvorrichtung 5 ist der Überprüfungsvorrichtung 1 entnehmbar und wieder in diese einsetzbar. Die Spiegelvorrichtung 5 wird beim Einsetzen mittels Ausrichtungselementen derart ausgerichtet, dass die Zentralachse 24 durch die Mitte der Spiegelanordnung bzw. durch die Mitte der Spiegel 60-67 verläuft.

Die Platte 13 bzw. das Blech weist in der Aufsicht eine rechteckige Form. Die Ecken der rechteckigen Form können abgerundet sein. Die Platte 13 bzw. das Blech ist aus einem Material, das von einem Magneten 9, 9', 9", 9‴ angezogen werden kann bzw. angezogen wird. Die Platte 13 bzw. das Blech kann z.B. aus einem ferromagnetischen Material bestehen. Die Platte 13 bzw. das Blech können insbesondere aus Metall bestehen. Auch Kunststoff, der durch einen Magnet 9, 9', 9", 9‴ angezogen werden kann, ist als Material der Platte 13 bzw. des Blechs vorstellbar.

Üblicherweise umfasst die Platte 13 bzw. Blech selbst keinen Magneten. Möglich ist jedoch auch, dass die Platte 13 bzw. das Blech selbst magnetisch ist und die Platte 13 bzw. das Blech an (z.B. ferromagnetischen) Metall der Spiegelvorrichtung 5, wobei die Spiegelvorrichtung 5 abgesehen von den Platten 13 bzw. Blechen keine Magnete aufweist, und/oder Magneten der Spiegelvorrichtung 5 magnetisch befestigt wird.

Die dem Spiegel 60-67 zugewandte Oberfläche der Platte 13 bzw. des Blechs weist eine deutlich größere Oberfläche auf als die Dicke der Platte 13 bzw. des Blechs, wobei die Dicke senkrecht zu der dem Spiegel 60-67 zugewandten Oberfläche der Platte 13 bzw. des Blechs verläuft.

In der Spiegelvorrichtung 5 sind acht Spiegelelemente 10, 10' bzw. acht Spiegel 60-67 angeordnet, die somit acht verschiedene Blickwinkel auf die Kabelspitze 23 ermöglichen.

Die Spiegelelemente 10, 10' sind mittels der Platte 13 bzw. des Blechs magnetisch mit der Spiegelvorrichtung 5 verbunden. Die Spiegelvorrichtung 5 weist Magnete 9, 9', 9", 9‴ auf zum Halten der Spiegelelemente 10, 10' an einer vorgegebenen Position.

Die Spiegelelemente 10, 10' sind zueinander baugleich ausgebildet. Somit ist die Spiegelvorrichtung 5 auch punksymmetrisch bezüglich eines Punkts auf der Zentralachse 24 ausgebildet.

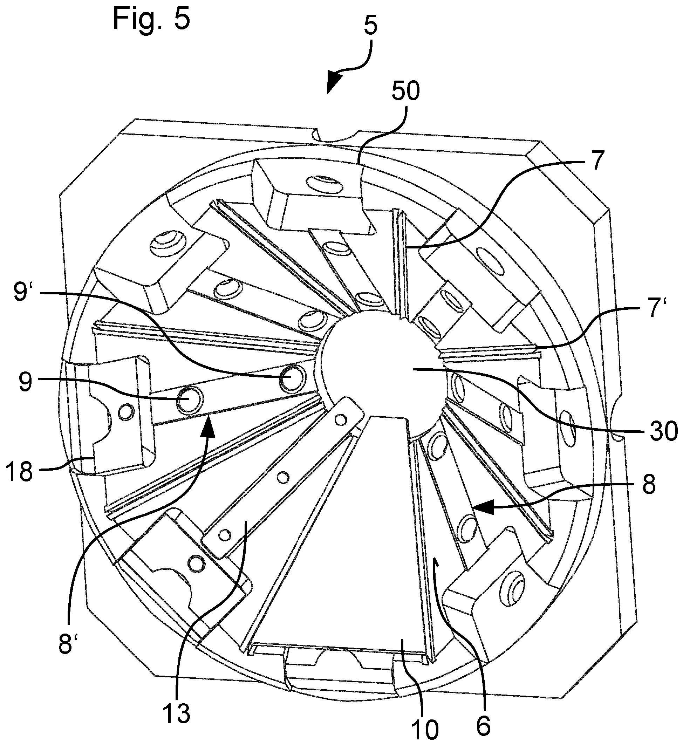

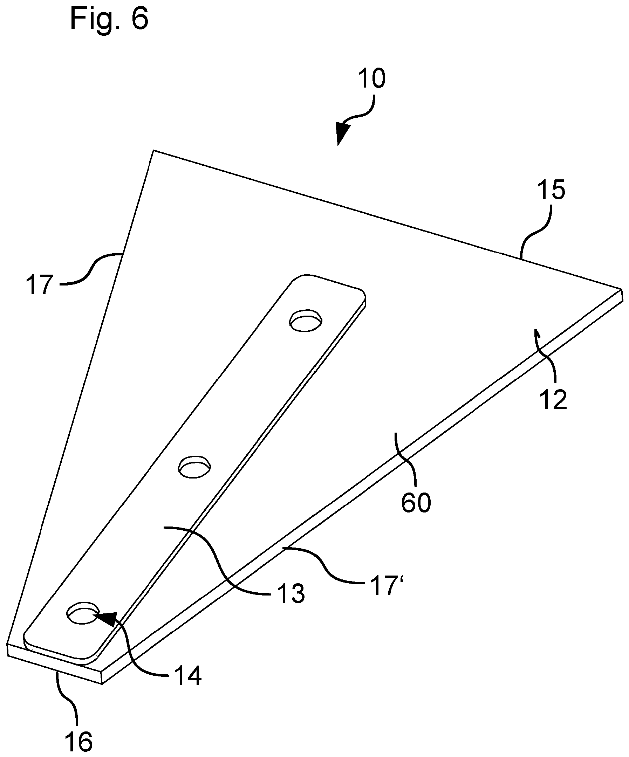

Fig. 5 zeigt eine perspektivische Ansicht der Spiegelvorrichtung 5 aus Fig. 3, ohne einige Spiegel 60-67. Fig. 6 zeigt eine perspektivische Ansicht eines Spiegelelements 10, 10' der Überprüfungsvorrichtung 1 aus Fig. 1 bzw. Fig. 2.

In Fig. 5 sind sieben der acht Spiegel 60-67 entfernt worden. Von einem Spiegelelement 10, 10' ist nur noch das Blech bzw. die Platte 13 vorhanden. Nur ein Spiegelelement 10, 10' ist vollständig in der Spiegelvorrichtung 5 vorhanden bzw. angeordnet.

Die Spiegelvorrichtung 5 weist für jeden der Spiegel 60-67 bzw. deren Spiegelrückfläche 12 eine Auflagefläche 6 auf. Wenn der Spiegel 60-67 bzw. das Spiegelelement 10, 10' in der Spiegelvorrichtung 5 installiert ist, ruht jeweils der größte Teil der Spiegelrückfläche 12 auf einer Auflagefläche 6. Die Auflagefläche 6 verläuft parallel zu der Spiegelrückfläche 12.

Die Auflageflächen 6 sind jeweils ein einem Winkel von 45° zu der Zentralachse 24 angeordnet. Die Auflageflächen 6 weisen zudem bei acht Spiegeln 60-67 einen Winkel von 45° (360°/8) zueinander auf. Bei mehr Spiegeln ist der Winkel entsprechend kleiner und bei weniger Spiegeln entsprechen größer.

Jeder der Spiegel 60-67 weist in Aufsicht eine trapezförmige Form auf.

Jeder der Auflageflächen 6 weist an ihrem Ende, das von der Zentralachse 24 abgewandt ist, eine Anschlagvertiefung 50 auf, in der ein Anschlag 18 angeordnet werden kann. Der Anschlag 18 liegt, wenn das Spiegelelement 10, 10' in der Spiegelvorrichtung 5 installiert ist, an einem ersten Ende der Platte 13 an, wobei das erste Ende der Platte 13 einen größeren Abstand zur Zentralachse 24 aufweist als das dem ersten Ende entgegengesetzte zweite Ende der Platte 13. Das zweite Ende der Platte 13 steht in die Kabelaufnahmeöffnung 30 hinein.

Der Anschlag 18 verhindert jeweils eine Bewegung des Spiegelelements 10, 10' weg von der Zentralachse 24. Der Anschlag 18 verhindert, wenn der Anschlag 18 sich in arretiertem Zustand befindet, ein Verschieben des Spiegelelements 10, 10' in eine Richtung entlang der Längsrichtung der Platte 13 bzw. des Blechs (die Längsrichtung verläuft entlang der größten Ausdehnung der Platte 13 bzw. des Blechs) bzw. parallel zu der Auflagefläche 6. Insbesondere Verschiebungen durch Vibrationen werden verhindert.

Die Anschläge lassen sich im nicht arretierten Zustand parallel zu dem Spiegelelement 10, 10' verschieben, d.h. die Anschläge sind in eine Richtung verschiebbar, die parallel zu der Auflagefläche 6 verläuft. Die Anschläge werden nach Einsetzen der Spiegelelemente 10, 10' an die Spiegelelemente 10, 10' herangeschoben, bis diese das der Zentralachse 24 abgewandte Ende der Platte 13 bzw. des Blechs des jeweiligen Spiegelelements 10, 10' berühren bzw. kontaktieren. Anschließend werden die Anschläge arretiert bzw. jeweils durch eine Schraube oder ähnliches an ihrer Position fixiert. Nun können die Spiegelelemente 10, 10' nicht mehr parallel zu der Auflagefläche 6 von der Zentralachse 24 weg verschoben werden.

Die Auflageflächen 6 weisen jeweils eine Aussparung 8, 8' auf. Die Aussparung 8, 8' verläuft jeweils weg von der Zentralachse 24. Die Aussparung 8, 8' ist mittig in der Auflagefläche 6 ausgebildet. Die Aussparung 8, 8' ist zum Aufnehmen der Platte 13 bzw. des Blechs des jeweiligen Spiegelelements 10, 10' ausgebildet. In der Aussparung 8, 8' sind in Vertiefungen Magnete 9, 9', 9", 9‴ zum Halten des jeweiligen Spiegelelements 10, 10' auf der Auflagefläche 6 angeordnet. Jede Aussparung 8, 8' weist zwei zueinander beabstandete Vertiefungen auf, in den jeweils ein Magnet 9, 9', 9", 9‴ angeordnet ist.

Die Magnete 9, 9', 9", 9‴ können jeweils ein Dauermagnet, wie z.B. ein Neodym-Magnet, und/oder ein Elektromagnet sein.

In Fig. 5 sind acht Spiegelelemente 10, 10' derart angeordnet, dass die Mitte der Spiegelelemente 10, 10' jeweils auf den Uhrzeigerpositionen 12 Uhr, 1 Uhr 30, 3 Uhr, 4 Uhr 30, sechs Uhr, 7 Uhr 30, 9 Uhr und 10 Uhr 30 angeordnet sind.

In Fig. 5 ist das untere ("auf 6 Uhr befindliche") Spiegelelement 10, 10' mit Spiegel 60-67 in die Spiegelvorrichtung 5 eingesetzt bzw. in der Spiegelvorrichtung 5 angeordnet. Bei der nächsten Auflagefläche 6 in Uhrzeigerrichtung neben dem eingesetzten Spiegelelement 10, 10' ("auf 7 Uhr 30") ist nur das Blech bzw. die Platte 13 des Spiegelelements 10, 10' in die Spiegelvorrichtung 5 eingesetzt. Dies dient nur zu Illustration. Das Blech bzw. die Platte 13 ist üblicherweise fest mittels einer Klebeverbindung mit dem Spiegel 60-67 verbunden. Bei den übrigen sechs Bereichen bzw. Auflageflächen 6 der Spiegelvorrichtung 5 ist kein Spiegel und auch keine Platte 13 bzw. kein Blech vorhanden. Bei der nächsten Auflagefläche 6 in Uhrzeigerrichtung ("auf 9 Uhr") sind zwei Magnete 9, 9' in den Vertiefungen der Aussparung 8' angeordnet, in den übrigen Bereichen sind die Magnete 9, 9', 9", 9‴ durch das Spiegelelement 10, 10' oder die Platte 13 verdeckt oder nicht eingesetzt.

Jeder der Spiegel 60-67 liegt, wenn das jeweilige Spiegelelement 10, 10' in der Spiegelvorrichtung 5 eingesetzt ist, mit zwei schräg zueinander verlaufenden Längsseiten bzw. Schenkeln 17, 17' der Trapezform des Spiegels 60-67 an jeweils einer seitlichen Spiegelbegrenzung 7, 7' an. Dies ist Fig. 5 gut zu sehen. Zwischen jeder Auflagefläche 6 sind zwei Spiegelbegrenzungen 7, 7' angeordnet. Die Spiegelbegrenzung 7, 7' ist jeweils eine Fläche, die jeweils senkrecht zu der Auflagefläche 6 vom Rand der Auflagefläche 6 hervorsteht. Zwischen zwei zueinander unmittelbar benachbarten Auflageflächen 6 bilden die Spiegelbegrenzungen 7, 7' eine prismatische Form, da zwei zueinander unmittelbar benachbarten Auflageflächen 6 in einem Winkel zueinander stehen bzw. in einem Winkel zueinander verlaufen. Somit befinden sich zwischen je zwei Spiegeln 60-67 zwei Spiegelbegrenzungen 7, 7'. Jede Auflagefläche 6 wird somit seitlich mit jeweils zwei Spiegelbegrenzungen 7, 7' begrenzt.

Die Spiegelbegrenzungen 7, 7' verhindern eine Bewegung der Spiegel 60-67 in eine erste Raumrichtung bzw. entgegengesetzt zu einer ersten Raumrichtung, die senkrecht zur Längsrichtung des Blechs bzw. der Platte 13 (die Längsrichtung erstreckt entlang der größten Ausdehnung des Blechs bzw. der Platte 13) und parallel zur Auflagefläche 6 verläuft. Die Spiegelbegrenzungen 7, 7' sorgen somit für eine Ausrichtung der Spiegel 60-67 entlang einer ersten Raumdimension, die für jeden Spiegel 60-67 in eine andere Richtung verläuft.

Durch die konische Form der Anordnung der Spiegelelemente 10, 10' bzw. der Spiegel 60-67 können die Spiegel 60-67 nur bis zu einem bestimmten Punkt auf der Auflagefläche 6 in Richtung der Zentralachse 24 verschoben werden. Wenn die Spiegel 60-67 mit ihren Schenkeln 17, 17' an die Spiegelbegrenzungen 7, 7' anstoßen, befindet sich der Spiegel 60-67 in der richtigen Position relativ zu den anderen Spiegeln 60-67 bzw. zu der Zentralachse 24. Anschließend werden die Anschläge an die von der Zentralachse 24 abgewandte Seite des jeweiligen Spiegel 60-67 bewegt und arretiert.

Die Auflagefläche 6 richtet die Spiegel 60-67 in einer Position in einer zweiten Raumrichtung relativ zu den anderen Spiegeln 60-67 bzw. relativ zu der Zentralachse 24 aus. Die zweite Raumrichtung verläuft senkrecht zur ersten Raumrichtung. Die erste Raumrichtung verläuft senkrecht zur Längsrichtung des Blechs bzw. der Platte 13 (die Längsrichtung erstreckt entlang der größten Ausdehnung des Blechs bzw. der Platte 13) und parallel zur Auflagefläche 6. Durch die Auflagefläche 6 kann der Spiegel 60-67 in Fig. 5 nicht in die Bildebene hinein verschoben werden, da der Spiegel 60-67 mit seiner Spiegelrückfläche 12 auf der Auflagefläche 6 aufliegt.

Wenn die Platte 13 bzw. das Blech in der Aussparung 8, 8' aufgenommen ist, ist das Spiegelelement 10, 10' durch die Magnete 9, 9', 9", 9‴ an der Spiegelvorrichtung 5 befestigt und durch die Spiegelbegrenzungen 7, 7', die Auflagefläche 6 und den Anschlag 18 in drei zueinander im Wesentlichen senkrecht zueinander verlaufenden Raumrichtungen fixiert bzw. relativ zu der Zentralachse 24 in einer vorgegebenen Position ausgerichtet.

Die Magnete 9, 9', 9", 9‴ ziehen das Blech bzw. die Platte 13 des jeweiligen Spiegelelements 10, 10' magnetisch an.

Wenn die Platte 13 bzw. das Blech in der Aussparung 8, 8' aufgenommen ist und die Spiegelrückfläche 12 größtenteils auf der Auflagefläche 6 aufliegt, berührt das Spiegelelement 10, 10' die Magnete 9, 9', 9", 9‴ nicht. Die Magnete 9, 9', 9", 9‴ weisen jeweils einen Abstand von z.B. ca. 0,1 mm zu dem jeweiligen Blech bzw. zur jeweiligen Platte 13 auf.

Die Platten 13 stehen zusammen mit den Spiegeln 60-67 jeweils etwas in die Kabelaufnahmeöffnung 30 hinein, wie dies in Fig. 5 für den unteren Spiegel 60-67 dargestellt ist.

Fig. 6 zeigt eine perspektivische Ansicht eines Spiegelelements 10, 10' der Überprüfungsvorrichtung 1 aus Fig. 1 bzw. Fig. 2.

Die Spiegel 60-67 sind jeweils mittels einer bzw. mehreren Klebverbindungen bzw. mittels Klebstoffs mit den Platten 13 bzw. Blechen verbunden. Jeder Spiegel 60-67 ist mit genau einer Platte 13 bzw. einem Blech verklebt.

Jede Platte 13 bzw. jedes Blech weist eine oder mehrere Klebeaussparungen 14 auf. Die Klebeaussparungen 14 der Platte 13 bzw. des Blechs sind zum Aufnehmen von Klebstoff zum Herstellen der Klebverbindung zwischen Platte 13 bzw. Blech und Spiegel 60-67 ausgebildet. In Fig. 6 weist die Platte 13 bzw. das Blech drei im Querschnitt kreisrunde Klebeaussparungen 14 auf. Die beiden äußeren Klebeaussparungen 14 weisen jeweils einen gleichen Abstand zu den Enden der Platte 13 bzw. des Blechs auf. Die mittlere Klebeaussparung 14 ist in der Mitte zwischen den beiden äußeren Klebeaussparungen 14 ausgebildet.

Die Klebeaussparungen 14 verlaufen durch die vollständige Dicke des Blechs bzw. der Platte 13, so dass ein zylindrisches Loch vorhanden ist. Das Loch verläuft parallel zu der Dicke des Blechs bzw. der Platte 13.

In die Klebeaussparungen 14 wird Klebestoff eingebracht. Die Kontaktfläche zwischen dem Klebstoff und dem Spiegel 60-67 entspricht jeweils der Fläche des Durchmessers der Klebeaussparung 14, wobei der Durchmesser senkrecht zur Oberfläche des Spiegels 60-67 verläuft. Somit befindet sich nur auf dem Teil der Spiegelrückfläche 12 Klebstoff, der durch das Loch bzw. die Klebeaussparung 14 durch das Blech bzw. die Platte 13 sichtbar ist. Der Klebstoff weist somit im Wesentlichen die Form eines geraden/senkrechten Kreiszylinders auf, wobei die Oberseite des senkrechten Kreiszylinders (d.h. die der Spiegelrückfläche 12 zugewandte kreisförmige Seite des senkrechten Kreiszylinders) die Kontaktfläche zwischen dem Klebstoff und der Spiegelrückfläche 12 ist. Das Spiegelelement 10 in Fig. 6 zeigt mit seiner Rückseite bzw. Spiegelrückfläche 12 nach oben. Dies bedeutet, dass die spiegelnde Seite bzw. die reflektierende Seite des Spiegels 60-67 in Fig. 6 nicht zu sehen ist. Die Spiegelrückfläche 12 ist somit nur über drei kleine Kontaktflächen mit dem Blech bzw. der Platte 13 verklebt.

Das Blech bzw. die Platte 13 kann an der dem Spiegel 60-67 abgewandten Ende der Klebeaussparung 14 eine Fase aufweisen. Hierdurch wird der ausgehärtete Klebstoff zusätzlich formschlüssig im Blech bzw. an der Platte 13 gesichert wie dies unter der Bezeichnung Epoxid-Niet unter anderem zur Befestigung des Rückspiegels an der Windschutzscheibe eines Kraftfahrzeugs bekannt ist. Folglich wird die Verbindung zwischen dem Klebstoff und der Platte 13 verbessert und somit auch die Klebverbindung zwischen Platte 13 und Spiegel 60-67.

Durch die geringe Verbindungs-/Kontaktfläche bzw. Klebefläche zwischen Spiegel 60-67 und Platte 13, treten auch bei Größenänderungen des Blechs bzw. der Platte 13 und/oder des Spiegels 60-67 durch Temperaturunterschiede keine mechanischen Spannungen in dem Spiegel 60-67 auf. Außerhalb der Verbindungs-/Kontaktfläche bzw. der Klebefläche bzw. der Klebeflächen sind der Spiegel 60-67 und die Platte 13 bzw. das Blech nicht fest miteinander verbunden.

Das jeweilige Blech bzw. die jeweiligen Platte 13 schließt mit einem seiner Enden plan mit der zweiten Grundseite 16 bzw. der kürzesten der beiden parallel zueinander verlaufenden Seiten des Spiegels 60-67 ab. Das andere Ende des Blechs ist beabstandet zu der Basis 15 bzw. der längsten der beiden parallel zueinander verlaufenden Seiten des Spiegels 60-67 angeordnet.

Zum Reinigen wird die Spiegelvorrichtung 5 aus der Überprüfungsvorrichtung 1 ausgebaut bzw. der Überprüfungsvorrichtung 1 entnommen. Die Anschläge werden gelöst bzw. von den Spiegel 60-67 entfernt. Die Spiegelelemente 10, 10' bzw. Spiegel 60-67 lassen sich nun an der Basis 15 und an der zweiten Grundseite 16 halten und die Spiegelelemente 10, 10' aus der Spiegelvorrichtung 5 entnehmen. Hierdurch wird die magnetische Verbindung zwischen Blech/Platte 13 und Magnet(en) 9, 9', 9", 9‴ gelöst.

Die Spiegelelemente 10, 10' lassen sich auf einer weiteren Magnethalterung magnetisch halten. Auf der Magnethalterung lassen sich die Spiegelelementen 10, 10' nun mit Reinigungsmitteln (z.B. Flüssigkeit und Tuch) und/oder mit einer Polymerlösung zum Abziehen vom Schmutz befreien bzw. säubern. Bei der Verwendung der Polymerlösung wird der Schmutz aufgenommen und kann nach dem Aushärten als Film abgezogen werden (evtl. unterstützt durch ein Trägertuch).

Auch anderer Arten der Reinigung der Spiegel 60-67 sind vorstellbar.

Nach dem Reinigen werden sie Spiegelelemente 10, 10' wieder in die Spiegelvorrichtung 5 eingesetzt. Hierbei werden die Spiegelelemente 10, 10' durch die Spiegelbegrenzungen 7, 7' und die Auflagefläche 6 ausgerichtet. Die Spiegel 60-67 werden jeweils mit ihrer Spiegelrückfläche 12 auf die Auflagefläche 6 gelegt, dabei gelangt das jeweilige Blech bzw. die Platte 13 in die jeweilige Aussparung. Spätestens wenn die Spiegel 60-67 jeweils mit ihrer Spiegelrückfläche 12 auf der Auflagefläche 6 aufliegen, wird das Blech bzw. die Platte 13 des jeweiligen Spiegelelements 10, 10' von den Magneten 9, 9', 9", 9‴ angezogen. Nun herrscht zwischen den Magneten 9, 9', 9", 9‴ und den Spiegelelementen 10, 10' eine magnetische Anziehungskraft, die zum Lösen der Spiegel 60-67 von der Auflagefläche 6 bzw. der Spiegelelemente 10, 10' von der Spiegelvorrichtung 5 überwunden werden muss. Durch die Magnete 9, 9', 9", 9‴ fallen insbesondere Spiegelelemente 10, 10' in der oberen Hälfte bzw. im oberen Teil der Spiegelvorrichtung 5 (d.h. Spiegelelemente 10, 10', bei denen sich die Spiegel 60-67 unterhalb der Auflagefläche 6 befinden) nicht durch die Gravitation herunter, sondern werden von den Magneten 9, 9', 9", 9‴ gehalten. Die Schenkel 17, 17' der trapezförmigen Spiegel 60-67 werden an die Spiegelbegrenzungen 7, 7' herangeschoben, bis die Schenkel 17, 17' die Spiegelbegrenzungen 7, 7' kontaktieren bzw. berühren. Dann werden die Anschläge an die Basis 15 des Spiegels 60-67 gebracht und fixiert bzw. arretiert. Die Schrauben der Anschläge sind vorzugsweise mit einem O-Ring gegen Verlieren gesichert.

Ohne weitere Justiervorgänge sind die Spiegel 60-67 nun in der Spiegelvorrichtung 5 richtig bzw. präzise angeordnet und ausgerichtet. Die Spiegelvorrichtung 5 kann nun in die Überprüfungsvorrichtung 1 eingesetzt werden. Die Spiegelvorrichtung 5 kann durch Ausrichtungselemente präzise in der Überprüfungsvorrichtung 1 ausgerichtet werden.

Auf ähnliche Weise können auch beschädigte Spiegel 60-67 bzw. Spiegelelemente 10, 10' ausgetauscht bzw. ersetzt werden.

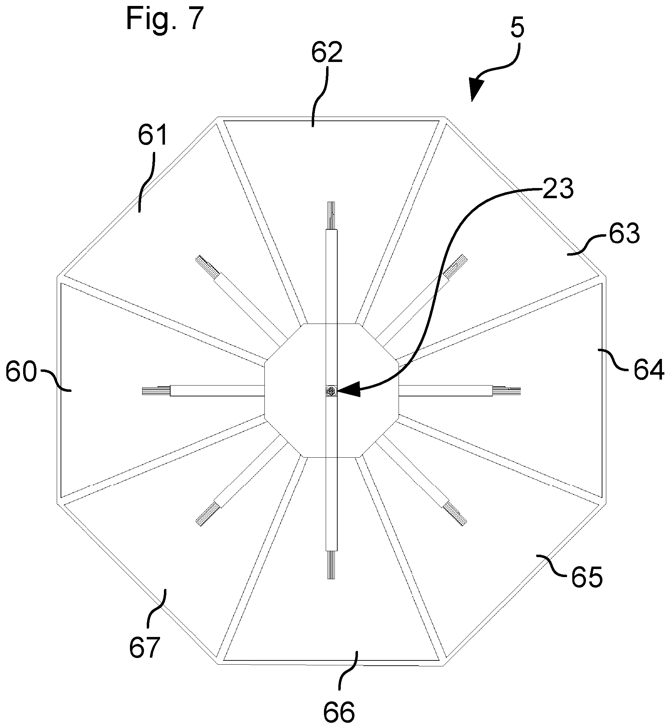

Fig. 7 zeigt ein mit der Überprüfungsvorrichtung 1 aus Fig. 1 aufgenommenes Bild der Kabelspitze 23. In Fig. 7 ist gut zu erkennen, wie die acht Spiegel 60-67 der Spiegelanordnung unterschiedliche Ansichten der Kabelspitze 23 bzw. des Kabels 40 bzw. Ansichten aus unterschiedlichen Blickwinkeln liefern/ergeben. In der Reflexion bzw. Spiegelung der Kabelspitze 23 des rechten Spiegels 64 ("auf 3 Uhr") und des linken Spiegels 60 ("auf 9 Uhr") ist besonders deutlich zu erkennen, dass eine der Litzen des Kabels 40 bzw. der Kabelspitze 23 zu kurz geschnitten ist. In den übrigen Reflexionen bzw. Spiegelungen der anderen Spiegel 61-63, 65-67 ist dies schwerer zu erkennen bzw. festzustellen.

Diese Ungleichmäßigkeit der Litzen kann durch die Auswertungssoftware erkannt werden und das Kabel 40 entsprechend als fehlerhaft markiert werden und/oder direkt als Ausschuss aussortiert werden.

Weitere Fehler, die durch die Überprüfungsvorrichtung 1 technisch einfach erkannt bzw. überprüft werden können, sind u.a., dass eine Litze des Kabels 40 herausgezogen ist, dass eine Litze des Kabels 40 abgespreizt ist, dass der vorgenommene Schnitt zum Abisolieren des Kabels 40 zu einer nicht-geraden Abisolierkante geführt hat, dass die Litzen des Kabels 40 schräg abgeschnitten wurden, dass eine Litze des Kabels 40 nicht mit einem Crimpkontakt vercrimpt wurde, ob Litzen in einer Kontrollbohrung des Kabels 40 parallel zueinander verlaufen, ob ein Kontaktelement, z.B. ein Crimpelement, das mit dem Kabel 40 verbunden wurde, vollständig entlang der Zentralachse 24 verläuft oder nicht (bzw. verbogen ist).

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### Bezugszeichenliste

- 1: Überprüfungsvorrichtung
- 2: Kamera
- 3: Beleuchtungseinrichtung
- 4: Spiegelkragen
- 5: Spiegelvorrichtung
- 6: Auflagefläche
- 7, 7': Spiegelbegrenzung
- 8, 8': Aussparung
- 9, 9', 9", 9‴: Magnet
- 10, 10': Spiegelelement
- 12: Spiegelrückfläche
- 13: Platte
- 14: Klebeaussparung
- 15: Basis
- 16: zweite Grundseite
- 17, 17': Schenkel
- 18: Anschlag
- 19: Scheibe
- 20: Druckluftreinigungsvorrichtung
- 21: Kabelzentrierung
- 22: Abdeckung
- 23: Kabelspitze
- 24: Zentralachse
- 30: Kabelaufnahmeöffnung
- 40: Kabel
- 45: Ringleuchte
- 50: Anschlagvertiefung
- 60-67: Spiegel

## Patentansprüche

1. Überprüfungsvorrichtung (1) zum Überprüfen einer Kabelspitze (23) eines Kabels (40), insbesondere eines verarbeiteten Kabels (40), vorzugsweise eines mit einem Crimpkontakt über eine Crimpverbindung verbundenen Kabels (40),
wobei die Überprüfungsvorrichtung (1) eine Spiegelvorrichtung (5) mit einer Zentralachse (24) aufweist, wobei die Kabelspitze (23) zum Überprüfen der Kabelspitze (23) entlang der Zentralachse (24) in der Spiegelvorrichtung (5) anordenbar ist,
wobei die Spiegelvorrichtung (5) mehrere in einem vorgegebenen Winkel zueinander und in einem vorgegebenen Winkel zu der Zentralachse (24) angeordnete Spiegelelemente (10, 10') jeweils umfassend einen Spiegel (60-67) zum Betrachten der entlang der Zentralachse (24) der Spiegelvorrichtung (5) angeordneten Kabelspitze (23) aus unterschiedlichen Blickwinkeln umfasst,
wobei die Überprüfungsvorrichtung (1) ferner eine Kamera (2) zum Erzeugen von Bildern der Kabelspitze (23) aus unterschiedlichen Blickwinkeln mittels der Spiegel (60-67) umfasst,
**dadurch gekennzeichnet, dass**
zumindest ein Teil der Spiegelelemente (10, 10'), insbesondere alle Spiegelelemente (10, 10'), in der Spiegelvorrichtung (5) von Magneten (9, 9', 9", 9‴) an ihrer jeweiligen Position gehalten werden.

2. Überprüfungsvorrichtung (1) nach Anspruch 1, wobei
die Spiegelelemente (10, 10') ferner jeweils eine Platte (13), insbesondere eine Metallplatte, aufweisen, wobei die Spiegel (60-67) jeweils mit der Platte (13), insbesondere mittels einer Klebeverbindung, fest verbunden sind, wobei die Platten (13) jeweils ein derartiges Material umfassen, dass die Platten (13) von Magneten (9, 9', 9", 9‴) angezogen werden können.

3. Überprüfungsvorrichtung (1) nach Anspruch 2, wobei
die Platten (13) jeweils eine Klebeaussparung (14) oder mehrere Klebeaussparungen zum Aufnehmen eines Klebstoffs der Klebeverbindung umfassen.

4. Überprüfungsvorrichtung (1) nach Anspruch 3, wobei
die jeweilige Platte (13) in der Klebeaussparung (14) an einem dem Spiegel (60-67) abgewandten Ende eine Fase zum verbesserten Verbinden des Klebstoffs mit der Platte (13) aufweist.

5. Überprüfungsvorrichtung (1) nach Anspruch 3 oder 4, wobei
die jeweilige Größe der Kontaktfläche des Klebstoffs mit dem jeweiligen Spiegel (60-67) im Wesentlichen einem Durchmesser der jeweiligen Klebeaussparung (14) zum Aufnehmen des Klebstoffs parallel zu der Oberfläche der Platte (13) entspricht.

6. Überprüfungsvorrichtung (1) nach einem der Ansprüche 2-5, wobei
die Spiegelvorrichtung (5) Auflageflächen (6) zum Aufliegen von Spiegelrückflächen (12) der Spiegel (60-67) der Spiegelelemente (10, 10') umfasst, wobei die Auflageflächen (6) jeweils eine Aussparung (8, 8') zum Aufnehmen der jeweiligen Platte (13) aufweisen.

7. Überprüfungsvorrichtung (1) nach einem der Ansprüche 2-6, wobei Anschläge (18) an den der Zentralachse (24) der Überprüfungsvorrichtung (1) abgewandten Enden der Platten (13) zum Halten der Spiegelelemente (10, 10') in jeweils einer vorgegebenen Position in der Spiegelvorrichtung (5) angeordnet sind.

8. Überprüfungsvorrichtung (1) nach einem der vorhergehenden Ansprüche, wobei die Spiegelvorrichtung (5) eine Vielzahl von seitlichen Spiegelbegrenzungen (7, 7') aufweist, wobei die seitlichen Spiegelbegrenzungen (7, 7') an jeweils zwei einander gegenüberliegenden Seiten des jeweiligen Spiegels (60-67) zum Halten des jeweiligen Spiegels (60-67) in einer vorgegebenen Position angeordnet sind.

9. Überprüfungsvorrichtung (1) nach einem der Ansprüche 2-8, wobei
die Platten (13) der Spiegelelemente (10, 10') jeweils beabstandet zu den Magneten (9, 9', 9", 9‴) angeordnet sind.

10. Überprüfungsvorrichtung (1) nach einem der Ansprüche 2-9, wobei jeder der Spiegel (60-67) in einer Aufsicht eine trapezförmige Form aufweist, und wobei ein Ende der Platte (13) plan mit der kürzeren der beiden parallel zueinander verlaufenden Seiten des Spiegels (60-67) abschließt.

11. Überprüfungsvorrichtung (1) nach einem der vorhergehenden Ansprüche, wobei die Spiegelvorrichtung (5) bezüglich der Zentralachse (24) spiegelsymmetrisch ausgebildet ist.

12. Überprüfungsvorrichtung (1) nach einem der Ansprüche 6-11, wobei jedes Spiegelelement (10, 10') mittels zwei Magneten (9, 9', 9", 9‴) an der Spiegelvorrichtung (5) befestigt ist, wobei die Magnete (9, 9', 9", 9‴) in Vertiefungen der Aussparung (8, 8') angeordnet sind.

13. Verfahren zum Reinigen der Spiegel (60-67) einer Überprüfungsvorrichtung (1) zum Überprüfen einer Kabelspitze (23) eines Kabels (40) nach einem der vorhergehenden Ansprüche,
wobei die Überprüfungsvorrichtung (1) eine Spiegelvorrichtung (5) mit einer Zentralachse (24) aufweist, wobei die Kabelspitze (23) zum Überprüfen der Kabelspitze (23) entlang der Zentralachse (24) in der Spiegelvorrichtung (5) anordenbar ist,
wobei die Spiegelvorrichtung (5) mehrere in einem vorgegebenen Winkel zueinander und in einem vorgegebenen Winkel zu der Zentralachse (24) angeordnete Spiegelelemente (10, 10') jeweils umfassend einen Spiegel (60-67) zum Betrachten der entlang der Zentralachse (24) der Spiegelvorrichtung (5) angeordneten Kabelspitze (23) aus unterschiedlichen Blickwinkeln umfasst,
wobei die Überprüfungsvorrichtung (1) ferner eine Kamera (2) zum Erzeugen von Bildern der Kabelspitze (23) aus unterschiedlichen Blickwinkeln mittels der Spiegel (60-67) umfasst,
wobei das Verfahren folgende Schritte umfasst:
Herausnehmen der Spiegelvorrichtung (5) aus der Überprüfungsvorrichtung (1); Lösen einer magnetischen Verbindung zwischen mindestens einem der Spiegelelemente (10, 10') und der Spiegelvorrichtung (5) und Entnehmen des mindestens einen Spiegelelements (10, 10') aus der Spiegelvorrichtung (5);
Reinigen des Spiegels (60-67) des mindestens einen Spiegelelements (10, 10'), Einsetzen des gereinigten mindestens einen Spiegelelements (10, 10') in die Spiegelvorrichtung (5) in einer vorgegebenen Position und Befestigen des Spiegelelements (10, 10') mittels eines Magneten (9, 9', 9", 9‴) an der Spiegelvorrichtung (5); und
Einsetzen der Spiegelvorrichtung (5) in die Überprüfungsvorrichtung (1).

14. Verfahren nach Anspruch 13, ferner folgenden Schritt umfassend:
Befestigen des mindestens einen Spiegelelements (10, 10') an einer Spiegelhaltevorrichtung mittels Magneten (9, 9', 9", 9‴) zum Halten des Spiegelelements (10, 10') während des Reinigens des Spiegels (60-67).

## Claims

1. Inspection apparatus (1) for inspecting a cable tip (23) of a cable (40), in particular a processed cable (40), preferably a cable (40) connected to a crimp contact via a crimp connection,
the inspection apparatus (1) having a mirror apparatus (5) with a central axis (24), the cable tip (23) being able to be arranged in the mirror apparatus (5) along the central axis (24) for the inspection of the cable tip (23),
the mirror apparatus (5) comprising a plurality of mirror elements (10, 10') arranged at a predetermined angle to one another and at a predetermined angle to the central axis (24), each comprising a mirror (60-67) for viewing the cable tip (23) arranged along the central axis (24) of the mirror apparatus (5) from different viewing angles,
the inspection apparatus (1) further comprising a camera (2) for generating images of the cable tip (23) from different viewing angles by means of the mirrors (60-67),
**characterized in that**
at least some of the mirror elements (10, 10'), in particular all of the mirror elements (10, 10'), are held in their respective positions in the mirror apparatus (5) by magnets (9, 9', 9", 9‴).

2. Inspection apparatus (1) according to claim 1, wherein
the mirror elements (10, 10') also each have a plate (13), in particular a metal plate, wherein the mirrors (60-67) are each fixedly connected to the plate (13), in particular by means of an adhesive bond, wherein the plates (13) each comprise such a material that the plates (13) can be attracted by magnets (9, 9', 9", 9‴).

3. Inspection apparatus (1) according to claim 2, wherein
the plates (13) each comprise an adhesive recess (14) or a plurality of adhesive recesses for receiving an adhesive of the adhesive bond.

4. Inspection apparatus (1) according to claim 3, wherein
each plate (13) has a bevel in the adhesive recess (14) on an end facing away from the mirror (60-67) for improved bonding of the adhesive to the plate (13).

5. Inspection apparatus (1) according to claim 3 or 4, wherein
the particular size of the contact surface of the adhesive with each mirror (60-67) substantially corresponds to a diameter of the corresponding adhesive recess (14) for receiving the adhesive parallel to the surface of the plate (13).

6. Inspection apparatus (1) according to any of claims 2-5, wherein
the mirror apparatus (5) comprises support surfaces (6) for supporting mirror back surfaces (12) of the mirrors (60-67) of the mirror elements (10, 10'), wherein the support surfaces (6) each have a recess (8, 8') for receiving the corresponding plate (13).

7. Inspection apparatus (1) according to any of claims 2-6, wherein
stops (18) are arranged on the ends of the plates (13) facing away from the central axis (24) of the inspection apparatus (1) for holding each of the mirror elements (10, 10') in a predetermined position in the mirror apparatus (5).

8. Inspection apparatus (1) according to any of the preceding claims, wherein
the mirror apparatus (5) has a plurality of lateral mirror boundaries (7, 7'), wherein the lateral mirror boundaries (7, 7') are respectively arranged on two opposite sides of the corresponding mirror (60-67) for holding the corresponding mirror (60-67) in a predetermined position.

9. Inspection apparatus (1) according to any of claims 2-8, wherein
the plates (13) of the mirror elements (10, 10') are each spaced apart from the magnets (9, 9', 9", 9‴).

10. Inspection apparatus (1) according to any of claims 2-9, wherein
each of the mirrors (60-67) has a trapezoidal shape in plan view, and wherein one end of the plate (13) is flush with the shorter of the two mutually parallel sides of the mirror (60-67).

11. Inspection apparatus (1) according to any of the preceding claims, wherein the mirror apparatus (5) is symmetrically identical with respect to the central axis (24).

12. Inspection apparatus (1) according to any of claims 6-11, wherein
each mirror element (10, 10') is attached to the mirror apparatus (5) by means of two magnets (9, 9', 9", 9‴), wherein the magnets (9, 9', 9", 9‴) are arranged in depressions of the recess (8, 8').

13. Method for cleaning the mirror (60-67) of an inspection apparatus (1) for inspecting a cable tip (23) of a cable (40) according to any of the preceding claims,
the inspection apparatus (1) having a mirror apparatus (5) with a central axis (24), the cable tip (23) being able to be arranged in the mirror apparatus (5) along the central axis (24) for the inspection of the cable tip (23),
the mirror apparatus (5) comprising a plurality of mirror elements (10, 10') arranged at a predetermined angle to one another and at a predetermined angle to the central axis (24), each comprising a mirror (60-67) for viewing the cable tip (23) arranged along the central axis (24) of the mirror apparatus (5) from different viewing angles,
the inspection apparatus (1) further comprising a camera (2) for generating images of the cable tip (23) from different viewing angles by means of the mirrors (60-67),
wherein the method comprises the following steps:
removing the mirror apparatus (5) from the inspection apparatus (1); releasing a magnetic connection between at least one of the mirror elements (10, 10') and the mirror apparatus (5) and removing the at least one mirror element (10, 10') from the mirror apparatus (5);
cleaning the mirror (60-67) of the at least one mirror element (10, 10'); inserting the cleaned at least one mirror element (10, 10') into the mirror apparatus (5) in a predetermined position and attaching the mirror element (10, 10') to the mirror apparatus (5) by means of a magnet (9, 9', 9", 9‴); and
inserting the mirror apparatus (5) into the inspection apparatus (1).

14. Method according to claim 13, further comprising the following step: attaching the at least one mirror element (10, 10') to a mirror holding apparatus by means of magnets (9, 9', 9", 9‴) for holding the mirror element (10, 10') while cleaning the mirror (60-67).

## Revendications

1. Dispositif d'inspection (1) permettant d'inspecter une pointe de câble (23) d'un câble (40), en particulier d'un câble (40) usiné, de préférence d'un câble (40) relié à un contact à sertir par l'intermédiaire d'une liaison de sertissage,
dans lequel le dispositif d'inspection (1) présente un dispositif à miroirs (5) comportant un axe central (24), dans lequel la pointe de câble (23) peut être disposée dans le dispositif à miroirs (5) le long de l'axe central (24) pour inspecter la pointe de câble (23),
dans lequel le dispositif à miroirs (5) comprend plusieurs éléments à miroirs (10, 10') disposés selon un angle prédéfini les uns par rapport aux autres et selon un angle prédéfini par rapport à l'axe central (24) et comportant respectivement un miroir (60-67) pour observer la pointe de câble (23) disposée le long de l'axe central (24) du dispositif à miroirs (5) sous différents angles de vue,
dans lequel le dispositif d'inspection (1) comprend en outre une caméra (2) permettant de générer des images de la pointe de câble (23) à partir de différents angles de vue au moyen des miroirs (60-67),
**caractérisé en ce que**
au moins une partie des éléments à miroirs (10, 10'), en particulier tous les éléments à miroirs (10, 10'), sont maintenus dans leur position respective dans le dispositif à miroirs (5) par des aimants (9, 9', 9", 9‴).

2. Dispositif d'inspection (1) selon la revendication 1, dans lequel les éléments à miroirs (10, 10') présentent en outre respectivement une plaque (13), en particulier une plaque métallique, dans lequel les miroirs (60-67) sont respectivement reliés de manière fixe à la plaque (13), en particulier au moyen d'une liaison par adhésif, dans lequel les plaques (13) comprennent respectivement un matériau tel que les plaques (13) peuvent être attirées par des aimants (9, 9', 9", 9‴).

3. Dispositif d'inspection (1) selon la revendication 2, dans lequel les plaques (13) comprennent respectivement un évidement pour adhésif (14) ou plusieurs évidements pour adhésif permettant de recevoir un adhésif de la liaison par adhésif.

4. Dispositif d'inspection (1) selon la revendication 3, dans lequel la plaque (13) respective présente dans l'évidement pour adhésif (14), à une extrémité opposée au miroir (60-67), un chanfrein permettant d'améliorer la liaison de l'adhésif avec la plaque (13).

5. Dispositif d'inspection (1) selon la revendication 3 ou 4, dans lequel la taille respective de la surface de contact de l'adhésif avec le miroir (60-67) respectif correspond sensiblement à un diamètre de l'évidement pour adhésif (14) respectif destiné à recevoir l'adhésif parallèlement à la surface de la plaque (13).

6. Dispositif d'inspection (1) selon l'une des revendications 2 à 5, dans lequel le dispositif à miroirs (5) comprend des surfaces d'appui (6) pour l'appui de surfaces arrière de miroir (12) des miroirs (60-67) des éléments à miroirs (10, 10'), dans lequel les surfaces d'appui (6) présentent respectivement un évidement (8, 8') destiné à recevoir la plaque (13) respective.

7. Dispositif d'inspection (1) selon l'une des revendications 2 à 6, dans lequel des butées (18) sont disposées aux extrémités des plaques (13) opposées à l'axe central (24) du dispositif d'inspection (1) pour maintenir les éléments à miroirs (10, 10') dans respectivement une position prédéfinie dans le dispositif à miroirs (5).

8. Dispositif d'inspection (1) selon l'une des revendications précédentes, dans lequel le dispositif à miroirs (5) présente une pluralité de limites de miroir latérales (7, 7'), dans lequel les limites de miroir latérales (7, 7') sont disposées sur respectivement deux côtés opposés du miroir (60-67) respectif pour maintenir le miroir (60-67) respectif dans une position prédéfinie.

9. Dispositif d'inspection (1) selon l'une des revendications 2 à 8, dans lequel les plaques (13) des éléments à miroirs (10, 10') sont disposées respectivement à une certaine distance des aimants (9, 9', 9", 9‴).

10. Dispositif d'inspection (1) selon l'une des revendications 2 à 9, dans lequel chacun des miroirs (60-67) présente une forme trapézoïdale en vue de dessus, et dans lequel une extrémité de la plaque (13) se termine de manière plane avec le plus court des deux côtés du miroir (60-67) s'étendant en étant parallèles entre eux.

11. Dispositif d'inspection (1) selon l'une des revendications précédentes, dans lequel le dispositif à miroirs (5) est réalisé de manière à être symétrique en miroir par rapport à l'axe central (24).

12. Dispositif d'inspection (1) selon l'une des revendications 6 à 11, dans lequel chaque élément à miroir (10, 10') est fixé au dispositif à miroirs (5) au moyen de deux aimants (9, 9', 9", 9‴), dans lequel les aimants (9, 9', 9", 9‴) sont disposés dans des renfoncements de l'évidement (8, 8').

13. Procédé pour le nettoyage des miroirs (60-67) d'un dispositif d'inspection (1) permettant d'inspecter une pointe de câble (23) d'un câble (40) selon l'une des revendications précédentes,
dans lequel le dispositif d'inspection (1) présente un dispositif à miroirs (5) comportant un axe central (24), dans lequel la pointe de câble (23) peut être disposée dans le dispositif à miroirs (5) le long de l'axe central (24) pour inspecter la pointe de câble (23), dans lequel le dispositif à miroirs (5) comprend plusieurs éléments à miroirs (10, 10') disposés selon un angle prédéfini les uns par rapport aux autres et selon un angle prédéfini par rapport à l'axe central (24) et comportant respectivement un miroir (60-67) pour observer la pointe de câble (23) disposée le long de l'axe central (24) du dispositif à miroirs (5) sous différents angles de vue,
dans lequel le dispositif d'inspection (1) comprend en outre une caméra (2) permettant de générer des images de la pointe de câble (23) à partir de différents angles de vue au moyen des miroirs (60-67),
dans lequel le procédé comprend les étapes suivantes :
retrait du dispositif à miroirs (5) du dispositif d'inspection (1) ; rupture d'une liaison magnétique entre au moins l'un des éléments à miroirs (10, 10') et le dispositif à miroirs (5) et retrait de l'au moins un élément à miroir (10, 10') du dispositif à miroirs (5) ; nettoyage du miroir (60-67) de l'au moins un élément à miroir (10, 10') ; insertion de l'au moins un élément à miroir (10, 10') nettoyé dans le dispositif à miroirs (5) dans une position prédéfinie et fixation de l'élément à miroir (10, 10') au dispositif à miroirs (5) au moyen d'un aimant (9, 9', 9", 9‴) ; et
insertion du dispositif à miroirs (5) dans le dispositif d'inspection (1).

14. Procédé selon la revendication 13, comprenant en outre l'étape suivante : fixation de l'au moins un élément à miroir (10, 10') à un dispositif de maintien de miroir au moyen d'aimants (9, 9', 9", 9‴) pour maintenir l'élément à miroir (10, 10') pendant le nettoyage du miroir (60-67).
